# EUROPEAN PATENT SPECIFICATION

(11) **EP 1 973 963 B1**
(45) Date of publication and mention of the grant of the patent: **19.06.2013**
(21) Application number: 06827738.3
(22) Date of filing: 13.11.2006
(51) Int. Cl.: C08G 77/20, C08G 77/50, C08K 5/54, C08L 83/04, H01L 33/00, C08L 83/07

(54) **THERMALLY STABLE TRANSPARENT SILICONE RESIN COMPOSITIONS AND METHODS FOR THEIR PREPARATION AND USE**
THERMISCH STABILE TRANSPARENTE SILIKONHARZZUSAMMENSETZUNGEN UND VERFAHREN ZU IHRER HERSTELLUNG UND VERWENDUNG
COMPOSITIONS DE RÉSINE DE SILICONE TRANSPARENTE THERMOSTABLE ET PROCÉDÉS DE PRÉPARATION ET D'UTILISATION DESDITES COMPOSITIONS

(30) Priority: 17.01.2006 US 759501 P
(43) Date of publication of application: 01.10.2008
(73) Proprietor: Dow Corning Corporation, Midland, Michigan 48686-0994 (US)
(72) Inventor: BAHADUR, Maneesh, Midland, MI 48642 (US); NORRIS, Ann, Walstrom, Midland, MI 48642 (US); ZARISFI, Afrooz, Midland, MI 48640 (US)
(74) Representative: Gillard, Richard Edward
(86) International application number: PCT/US2006/043904
(87) International publication number: WO 2007/086987

(56) References cited:
- WO-A-2005/033207
- US-A- 4 032 502

## Description

### BACKGROUND OF THE INVENTION

Optically transparent silicone resin compositions having refractive index (RI) greater than 1.40 are useful for packaging light emitting diode (LED) devices. LEDs generally operate at 400 to 700 nm. In this application, an important characteristic of silicone materials is their transparent nature in the near visible region of 400 to 800 nanometers (nm). Silicone encapsulants generally do not adversely affect the emission spectrum of light from the LED and do not attenuate light output.

The RI of silicones increases as aromatic group content increases. Increasing aromatic group content is one approach to obtaining curable silicone compositions with RI > 1.40 for LED packaging applications. However, known silicone resins having refractive index of greater than 1.40 can compromise the LED performance because optical transmission of these silicone resins degrades over time. It is undesirable for light in the wavelength range from ultra-violet (UV) to yellow to be absorbed over time. This phenomenon is called yellowing because the silicone resin appears to have transformed from transparent to a yellow color after thermal aging.

### Problem to be Solved

There is a need for curable silicone resin compositions that form cured silicone resins having RI > 1.40 and minimal yellowing after thermal aging.

### BRIEF SUMMARY OF THE INVENTION

This invention relates to a curable silicone resin composition that upon cure forms a cured silicone resin having a refractive index greater than 1.40. The composition forms a cured silicone resin with an optical transparency > 95% at a thickness of 2.0 millimeters (mm) or less at 400 nm to 700 nm wavelength after heating at 200 °C for 14 days.

### BRIEF DESCRIPTION OF THE DRAWINGS

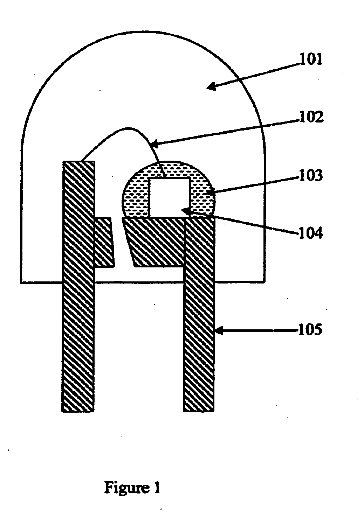

Figure 1 shows a cross section of an LED device with a cured silicone resin prepared from the composition of this invention.

### Reference Numerals

| | |
|---|---|
| 101 | dome |
| 102 | wire |
| 103 | soft silicone |
| 104 | LED chip |
| 105 | lead frame |

### DETAILED DESCRIPTION OF THE INVENTION

### Definitions and Usage of Terms

All amounts, ratios, and percentages are by weight unless otherwise indicated. The articles "a", "an", and "the" each refer to one or more. "Combination" means two or more items put together by any method. A "silylated acetylenic inhibitor" means any reaction product of an acetylenic alcohol inhibitor and a silane.

This invention relates to a curable silicone resin composition. The composition comprises:
(A) a polydiorganosiloxane having an average, per molecule, of at least two aliphatically unsaturated organic groups and at least one aromatic group;
(B) a branched polyorganosiloxane having an average, per molecule, of at least one aliphatically unsaturated organic group and at least one aromatic group;
(C) a polyorganohydrogensiloxane having an average per molecule of at least two silicon-bonded hydrogen atoms and at least one aromatic group,
(D) a hydrosilylation catalyst, and
(E) a silylated acetylenic inhibitor.
The curable silicone resin composition cures to form a cured silicone resin having a refractive index greater than 1.40. The composition cures to form a cured silicone resin with an optical transparency greater than 95% at a thickness of 2.0 mm or less at 400 nm wavelength after heating at 200 °C for 14 days, alternatively optical transparency greater than 95% at a thickness of 1.8 mm at 400 nm wavelength after heating at 200 °C for 14 days.

### Ingredient (A) Polydiorganosiloxane

Ingredient (A) is a polydiorganosiloxane having an average per molecule of at least two aliphatically unsaturated organic groups and at least one aromatic group. Ingredient (A) can be a single polydiorganosiloxane or a combination comprising two or more polydiorganosiloxanes that differ in at least one of the following properties: structure, viscosity, average molecular weight, siloxane units, and sequence. The viscosity of ingredient (A) is not critical, however, viscosity may range from 10 to 1,000,000 mPa·s at 25 °C, alternatively 100 to 50,000 mPa·s, to improve handling properties of the cured silicone resin prepared from the composition of this invention. The amount of ingredient (A) in the composition may range from 10 to 40, alternatively 15 to 30, parts by weight based on the total weight of the composition.

The unsaturated organic groups in ingredient (A) may be alkenyl exemplified by, but not limited to, vinyl, allyl, butenyl, pentenyl, and hexenyl, alternatively vinyl. The unsaturated organic groups may be alkynyl groups exemplified by, but not limited to, ethynyl, propynyl, and butynyl. The unsaturated organic groups in ingredient (A) may be located at terminal, pendant, or both terminal and pendant positions. The aromatic group or groups in ingredient (A) may be located at terminal, pendant, or both terminal and pendant positions. The aromatic group is exemplified by, but not limited to, phenyl, tolyl, xylyl, benzyl, styryl, and 2-phenylethyl, alternatively phenyl. Ingredient (A) contains an average of at least one aromatic group per molecule. However, ingredient (A) may contain more than 40 mol%, alternatively more than 45 mol% aromatic groups.

The remaining silicon-bonded organic groups in ingredient (A), if any, may be monovalent substituted and unsubstituted hydrocarbon groups free of aromatics and free aliphatic unsaturation. Monovalent unsubstituted hydrocarbon groups are exemplified by, but not limited to alkyl groups such as methyl, ethyl, propyl, pentyl, octyl, undecyl, and octadecyl and cycloalkyl groups such as cyclohexyl. Monovalent substituted hydrocarbon groups are exemplified by, but not limited to halogenated alkyl groups such as chloromethyl, 3-chloropropyl, and 3,3,3-trifluoropropyl, fluoromethyl, 2-fluoropropyl, 3,3,3-trifluoropropyl, 4,4,4-trifluorobutyl, 4,4,4,3,3-pentafluorobutyl, 5,5,5,4,4,3,3-heptafluoropentyl, 6,6,6,5,5,4,4,3,3-nonafluorohexyl, and 8,8,8,7,7-pentafluorooctyl.

Ingredient (A) may have general formula (I): R¹₃SiO-(R²₂SiO)ₐ-SiR¹₃, where each R¹ and each R² are independently selected from the group consisting of aliphatically unsaturated organic groups, aromatic groups, and monovalent substituted and unsubstituted hydrocarbon groups described above, and subscript a is an integer having a value sufficient to provide ingredient (A) with a viscosity ranging from 10 to 1,000,000 mPa·s at 25 °C, with the proviso that on average at least two of R¹ and/or R² are unsaturated organic groups and at least one of R¹ and/or R² is an aromatic group. Alternatively, at least two of R¹ are unsaturated organic groups, at least one of R² is an aromatic group, and subscript a has a value ranging from 5 to 1,000. Alternatively, formula (I) is an *α,ω*-dialkenyl-functional polydiorganosiloxane.

### Ingredient (B) Branched Polyorganosiloxane

Ingredient (B) is a branched polyorganosiloxane having an average, per molecule, of at least one unsaturated organic group and at least one aromatic group. Ingredient (B) can be a single polyorganosiloxane or a combination comprising two or more polydiorganosiloxanes that differ in at least one of the following properties: structure, viscosity, average molecular weight, siloxane units, and sequence. The molecular weight of ingredient (B) is not critical, however, weight average molecular weight (Mw) may range from 500 to 10,000, alternatively 700 to 3,000. Ingredient (B) may be added to the composition in an amount of 35 to 75 parts by weight based on the total weight of the composition.

Ingredient (B) comprises units of formula R³SiO_{3/2}, where each R³ is independently selected from the group consisting of aliphatically unsaturated organic groups, aromatic groups, and monovalent substituted and unsubstituted hydrocarbon groups described above, with the proviso that on average, per molecule, at least one of R³ is an aliphatically unsaturated organic group and at least one R³ is an aromatic group.

Ingredient (B) may have unit formula (II):

(R³SiO_{3/2})_{b}(R³₂SiO_{2/2})_{c}(R³₃SiO_{1/2})_{d}(SiO_{4/2})e(XO_{1/2})_{f},

where R³ is as described above, X is a hydrogen atom or a monovalent hydrocarbon group such as an alkyl group, b is a positive number, c is 0 or a positive number, d is 0 or a positive number, e is 0 or a positive number, f is 0 or a positive number, c/b is a number ranging from 0 to 10, d/b is a number ranging from 0 to 0.5, e/(b+c+d+e) is a number ranging from 0 to 0.3, and f/(b+c+d+e) is a number ranging from 0 to 0.4. In formula (II), the polyorganosiloxane contains an average of at least one unsaturated organic group per molecule, however, 0.1 mol% to 40 mol% of R³ may be unsaturated organic groups. In formula (II), the polyorganosiloxane contains an average of at least one aromatic group per molecule, however, at least 10 mol% of R³ may be aromatic groups. Furthermore, in the D unit of formula R³₂SiO_{2/2}, at least 30 mol% of R³ may be aromatic groups. The composition may contain 0 to 17%, alternatively 2 to 17% of ingredient (B) where f is a positive number.

### Ingredient (C) Polyorganohydrogensiloxane

Ingredient (C) is a polyorganohydrogensiloxane having an average, per molecule, of at least two silicon bonded hydrogen atoms and at least one aromatic group. Ingredient (C) can be a single polyorganohydrogensiloxane or a combination comprising two or more polyorganohydrogensiloxanes that differ in at least one of the following properties: structure, viscosity, average molecular weight, siloxane units, and sequence. The viscosity of ingredient (C) is not critical and may range from 1 to 1,000 mPa·s at 25 °C, alternatively 2 to 500 mPa·s. The aromatic groups are as exemplified above. Ingredient (C) may contain at least 15 mol%, alternatively at least 30 mol% aromatic groups.

Ingredient (C) may comprise a linear polyorganohydrogensiloxane of general formula (III): HR⁴₂SiO-(R⁴₂SiO)_{g}-SiR⁴₂H, where each R⁴ is independently a hydrogen atom, an aromatic group as exemplified above, or a monovalent substituted or unsubstituted hydrocarbon group free of aromatics and free aliphatic unsaturation as exemplified above, with the proviso that on average at least one R⁴ per molecule is an aromatic group, and g is an integer with a value of 1 or more. Alternatively, at least one R⁴ per molecule is phenyl and g may range from 1 to 20, alternatively 1 to 10.

Alternatively, ingredient (C) may comprise a branched polyorganohydrogensiloxane of unit formula (IV): (R⁵SiO_{3/2})ₕ(R⁵₂SiO_{2/2})ᵢ(R⁵₃SiO_{1/2})ⱼ(SiO_{4/2})ₖ(XO)ₘ where X is as described above. Each R⁵ is independently a hydrogen atom, an aromatic group as exemplified above, or a monovalent substituted or unsubstituted hydrocarbon group free of aromatics and free aliphatic unsaturation as exemplified above, with the proviso that an average of at least two per molecule of R⁵ are hydrogen atoms. In formula (IV), the polyorganohydrogensiloxane contains an average of at least two silicon bonded hydrogen atoms per molecule, however, 0.1 mol% to 40 mol% of R⁵ may be hydrogen atoms. In formula (IV), the polyorganosiloxane contains an average of at least one aromatic group per molecule, however, at least 10 mol% of R⁵ may be aromatic groups. Furthermore, in the D unit of formula R⁵₂SiO_{2/2}, at least 30 mol% of R⁵ may be aromatic groups.
In formula (IV), h is a positive number, i is 0 or a positive number, j is 0 or a positive number, k is 0 or a positive number, m is 0 or a positive number, i/h has a value ranging from 0 to 10, j/h has a value ranging from 0 to 5, k/(h+i+j+k) has a value ranging from 0 to 0.3, and m/(h+i+j+k) has a value ranging from 0 to 0.4.

The amount of ingredient (C) added to the composition may range from 10 to 50 parts by weight based on the total weight of the composition. The amount of ingredient (C) may be selected such that the amount of silicon bonded hydrogen atoms in the composition ranges from 0.1 mol to 10 mol, alternatively 0.1 to 5 mol, and alternatively 0.5 to 2 mol, per 1 mol of unsaturated organic groups in the composition.

### Ingredient (D) Hydrosilylation Catalyst

Ingredient (D) is a hydrosilylation catalyst. Ingredient (D) is added in an amount sufficient to promote curing of the composition of this invention. However, the amount of ingredient (D) may range from 0.01 to 1,000 ppm, alternatively 0.01 to 100 ppm, and alternatively 0.01 to 50 ppm of platinum group metal based on the weight of the composition.

Suitable hydrosilylation catalysts are known in the art and commercially available. Ingredient (D) may comprise a platinum group metal selected from the group consisting of platinum, rhodium, ruthenium, palladium, osmium or iridium metal or organometallic compound thereof, and a combination thereof. Ingredient (D) is exemplified by compounds such as chloroplatinic acid, chloroplatinic acid hexahydrate, platinum dichloride, and complexes of said compounds with low molecular weight organopolysiloxanes or platinum compounds microencapsulated in a matrix or coreshell type structure. Complexes of platinum with low molecular weight organopolysiloxanes include 1,3-diethenyl-1,1,3,3-tetramethyldisiloxane complexes with platinum. These complexes may be microencapsulated in a resin matrix. Alternatively, the catalyst may comprise 1,3-diethenyl-1,1,3,3-tetramethyldisiloxane complex with platinum. When the catalyst is a platinum complex with a low molecular weight organopolysiloxane, the amount of catalyst may range from 0.02 to 0.2 parts by weight based on the total weight of the composition.

Suitable hydrosilylation catalysts for ingredient (D) are described in, for example, U.S. Patents 3,159,601; 3,220,972; 3,296,291; 3,419,593; 3,516,946; 3,814,730; 3,989,668; 4,784,879; 5,036,117; and 5,175,325 and EP 0 347 895 B. Microencapsulated hydrosilylation catalysts and methods of preparing them are also known in the art, as exemplified in U.S. Patent No. 4,766,176; and U.S. Patent No. 5,017,654.

### Ingredient (E) Silylated Acetylenic Inhibitor

Ingredient (E) in the composition of this invention is a silylated acetylenic inhibitor. Without wishing to be bound by theory, it is thought that adding a silylated acetylenic inhibitor reduces yellowing of the cured silicone resin prepared from the composition of this invention as compared to a cured silicone resin prepared from a hydrosilylation curable composition that does not contain an inhibitor or that contains a conventional organic acetylenic alcohol inhibitor. Examples of conventional organic acetylenic alcohol inhibitors are disclosed, for example, in EP 0 764 703 A2 and U.S. Patent 5,449,802 and include 1-butyn-3-ol, 1-propyn-3-ol, 2-methyl-3-butyn-2-ol, 3-methyl-1-butyn-3-ol, 3-methyl-1-pentyn-3-ol, 3-phenyl-1-butyn-3-ol, 4-ethyl-1-octyn-3-ol, 3,5-diemthyl-1-hexyn-3-ol, and 1-ethynyl-1-cyclohexanol. The composition of this invention may be free of conventional organic acetylenic alcohol inhibitors. "Free of conventional organic acetylenic alcohol inhibitors" means that if any organic acetylenic alcohol is present in the composition, the amount present is insufficient to reduce optical transparency of the cured silicone resin to < 95% at a thickness of 2.0 mm or less at 400 nm wavelength after heating at 200 °C for 14 days.

Ingredient (E) may be added in an amount ranging from 0.001 to 1 parts by weight based on the total weight of the composition, alternatively 0.01 to 0.5 parts by weight. Suitable silylated acetylenic inhibitors for ingredient (E) may have general formula (V): 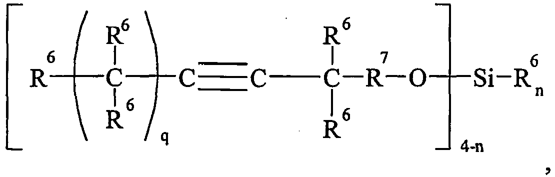 or
general formula (VI): 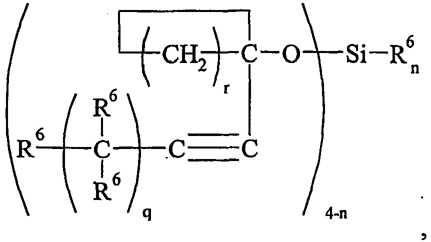 or a combination thereof;
where each R⁶ is independently a hydrogen atom or a monovalent organic group, and n is 0, 1, 2, or 3, q is 0 to 10, and r is 4 to 12. Alternatively n is 1 or 3. Alternatively, in general formula (V), n is 3. Alternatively, in general formula (VI), n is 1. Alternatively q is 0. Alternatively r is 5, 6, or 7, and alternatively r is 6. Examples of monovalent organic groups for R⁶ include an aliphatically unsaturated organic group, an aromatic group, or a monovalent substituted or unsubstituted hydrocarbon group free of aromatics and free aliphatic unsaturation, as described above.

Ingredient (E) is exemplified by (3-methyl-1-butyn-3-oxy)trimethylsilane, ((1,1-dimethyl-2-propynyl)oxy)trimethylsilane, bis(3-methyl-1-butyn-3-oxy)dimethylsilane, bis(3-methyl-1-butyn-3-oxy)silanemethylvinylsilane, bis((1,1-dimethyl-2-propynyl)oxy)dimethylsilane, methyl(tris(1,1-dimethyl-2-propynyloxy))silane, methyl(tris(3-methyl-1-butyn-3-oxy))silane, (3-methyl-1-butyn-3-oxy)dimethylphenylsilane, (3-methyl-1-butyn-3-oxy)dimethylhexenylsilane, (3-methyl-1-butyn-3-oxy)triethylsilane, bis(3-methyl-1-butyn-3-oxy)methyltrifluoropropylsilane, (3,5-dimethyl-1-hexyn-3-oxy)trimethylsilane, (3-phenyl-1-butyn-3-oxy)diphenylmethylsilane, (3-phenyl-1-butyn-3-oxy)dimethylphenylsilane, (3-phenyl-1-butyn-3-oxy)dimethylvinylsilane, (3-phenyl-1-butyn-3-oxy)dimethylhexenylsilane, (cyclohexyl-1-ethyn-1-oxy)dimethylhexenylsilane, (cyclohexyl-1-ethyn-1-oxy)dimethylvinylsilane, (cyclohexyl-1-ethyn-1-oxy)diphenylmethylsilane, (cyclohexyl-1-ethyn-1-oxy)trimethylsilane, and combinations thereof. Alternatively, ingredient (E) is exemplified by methyl(tris(1,1-dimethyl-2-propynyloxy))silane, ((1,1-dimethyl-2-propynyl)oxy)trimethylsilane, or a combination thereof.

Ingredient (E) may be prepared by methods known in the art for silylating an alcohol such as reacting a chlorosilane of formula R⁶ₙSiCl₄₋ₙ with an acetylenic alcohol of formula 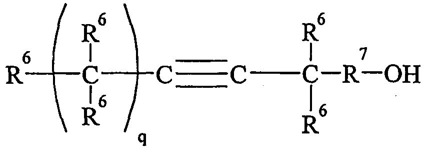 or 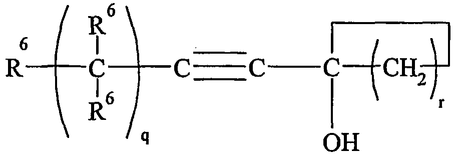 in the presence of an acid receptor. In these formulae, n, q, r, and R⁶ are as described above and R⁷ is a bond or a divalent hydrocarbon group. Examples of silylated acetylenic inhibitors and methods for their preparation are disclosed, for example, in EP 0 764 703 A2 and U.S. Patent 5,449,802.

### Optional Ingredients

The composition of this invention may further comprise one or more additional ingredients selected from the group consisting of (F) a mold release agent, (G) an optically active agent, (H) a filler, (I) an adhesion promoter, (J) a heat stabilizer, (K) a flame retardant, (L) a reactive diluent, and a combination thereof, provided however that the additional ingredients and amounts added do not render the curable silicone composition incapable of curing to form a cured silicone resin with an optical transparency > 95% at a thickness of 2.0 mm or less at 400 nm wavelength after heating at 200 °C for 14 days.

### Ingredient (F) Mold Release Agent

Ingredient (F) is an optional mold release agent. Ingredient (F) may comprise an *α,ω*-dihydroxy-functional polydiorganosiloxane that may be added to the composition in an amount ranging from 0% to 5%, alternatively 0.25% to 2% based on the weight of the composition. Ingredient (F) can be a single *α,ω*-dihydroxy-functional polydiorganosiloxane or a combination comprising two or more *α,ω*-dihydroxy-functional polydiorganosiloxanes that differ in at least one of the following properties: structure, viscosity, average molecular weight, siloxane units, and sequence. The viscosity of ingredient (F) is not critical and may range from 50 to 1,000 mPa·s at 25 °C. Ingredient (F) may contain at least one aromatic group per molecule, and the aromatic groups are as exemplified above. Ingredient (F) may contain at least 15 mol%, alternatively at least 30 mol% aromatic groups.

Ingredient (F) may comprise an *α,ω*-dihydroxy-functional polydiorganosiloxane of general formula (V): HOR⁸₂SiO-(R⁸₂SiO)₀-SiR⁸₂OH, where each R⁸ is independently an aromatic group as exemplified above, or a monovalent substituted or unsubstituted hydrocarbon group free of aromatics and free aliphatic unsaturation as exemplified above, with the proviso that on average at least one R⁸ per molecule is an aromatic group, and o is an integer with a value of 1 or more. Alternatively, at least one R⁸ per molecule is phenyl and o may range from 2 to 8.

### Ingredient (G) Optically Active Agent

Optional ingredient (G) is an optically active agent. Examples of ingredient (G) include optical diffusants, phosphor powders, photonic crystals, quantum dots, carbon nanotubes, dyes such as fluorescent dyes or absorbing dyes, and combinations thereof. The exact amount of ingredient (G) depends on the specific optically active agent selected, however, ingredient (G) may be added in an amount ranging from 0% to 20%, alternatively 1% to 10% based on the weight of the composition.

### Ingredient (H) Filler

Optional ingredient (H) is a filler. Suitable fillers are known in the art and are commercially available. For example, ingredient (H) may comprise an inorganic filler such as silica, glass, alumina, zinc oxide, or a combination thereof. The filler may have an average particle diameter of 50 nanometers or less and does not lower the percent transmittance by scattering or absorption. Alternatively, ingredient (H) may comprise an organic filler such as poly(meth)acrylate resin particles. Ingredient (H) may be added in an amount ranging from 0% to 50%, alternatively 1% to 5% based on the weight of the composition.

### Methods of Making the Composition

The curable silicone composition described above may be prepared by any convenient means, such as mixing all ingredients at ambient or elevated temperature. The compositions may be prepared as one-part compositions or multiple part compositions. In a multiple part composition, such as a two part composition, ingredients (C) and (D) are stored in separate parts. For example, a base part may be prepared by mixing ingredients comprising: 30 to 60 parts ingredient (A), 30 to 65 parts ingredient (B), and 0.0005 to 0.005 parts ingredient (D). The base part may optionally further comprise 0.2 to 5 parts ingredient (F). A curing agent part may be prepared by mixing ingredients comprising: 0 to 10 parts ingredient (A), 42 to 67 parts by weight ingredient (B), 20 to 50 parts by weight ingredient (C), and 0.001 to 1 part by weight ingredient (E). The base part and the curing agent part may be stored in separate containers until just prior to use, when the two parts are mixed together in a ratio of 1 to 10 parts base per 1 part curing agent.

### Methods of Using the Composition

The composition of this invention may be used to form a cured silicone resin. The composition may be cured at room temperature or with heating, however, heating the composition may accelerate curing. The composition may be heated at a temperature ranging from 50 to 200 °C for several minutes to several hours. The cured product obtained is a cured silicone resin.

The composition of this invention may be used for packaging optoelectronic devices, such as LED devices. For example, curable silicone composition may be molded and cured such that the cured silicone resin is formed as a hard lens. The lens may be tack free and resistant to dirt pick up. The composition of this invention may be used to form lenses in, for example, an injection molding process such as that disclosed in WO 2005/017995.

Alternatively, the composition of this invention may be used to encapsulate an LED device, such as that disclosed in U.S. Patent 6,204,523 or WO 2005/033207. Figure 1 shows a cross section of an LED device with a cured silicone resin prepared from the composition of this invention. The LED device includes an LED chip 104 encapsulated in a soft silicone 103, such as a rubber or gel. The LED chip 104 is bonded to lead frame 105 by wire 102. The LED chip 104, wire 102, and soft silicone 103 are surrounded by dome 101, which is made of a cured silicone resin of this invention.

### EXAMPLES

The following examples are included to demonstrate the invention to one of ordinary skill in the art. However, those of skill in the art should, in light of the present disclosure, appreciate that many changes can be made in the specific embodiments which are disclosed and still obtain a like or similar result without departing from the spirit and scope of the invention set forth in the claims.

In these examples, M^{Vi}₂D^{Ph,Me}ₓ is dimethyl,vinyl siloxy-terminated methyl, phenyl siloxane, with a viscosity ranging from 500 to 50,000 cSt and x ranging from 50 to 500. Alternatively, viscosity may range from 2,000 to 25,000 cSt, and x may range from 100 to 250. M^{Vi}_{0.25}T^{Ph}_{0.75} is a solution of 45 parts toluene and 55 parts vinyl terminated phenylsilsesquioxane resin. The resin is a solid. M^{H}_{0.6}T^{Ph}_{0.4} is a mixture of 98 parts hydrogen-terminated phenylsilsesquioxane and 2 parts phenyltris(dimethylhydrogensiloxy)silane with a viscosity ranging from 1 to 100 mPa·s. Mold Release Agent is hydroxy-terminated methyl, phenyl polysiloxane of formula: 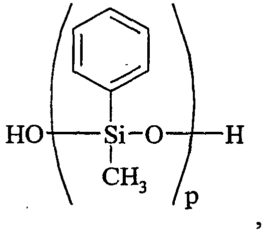 where p is an integer ranging from 3 to 10. Pt is a mixture of 38 parts tetramethyldivinyldisiloxane and 62 parts 1,3-diethenyl-1,1,3,3 -tetramethyldisiloxane complexes with platinum. Etch is 1-ethynyl-1-cyclohexanol. Inhibitor is methyl(tris(1,1-dimethyl-2-propynyloxy))silane. In the formulae above, Me represents a methyl group, Ph represents a phenyl group, Vi represents a vinyl group, M represents a monofunctional siloxane unit, D represents a difunctional siloxane unit, and T represents a trifunctional siloxane unit.

### Comparative Example 1 - Effect of Inhibitor

A sample was prepared by mixing the following ingredients: 54 parts M^{Vi}_{0.25}T^{Ph}_{0.75}, 24 parts M^{Vi}₂D^{Ph,Me}x, 21 parts M^{H}₀.₆T^{Ph}₀.₄, 1 part Mold Release Agent, 2 parts Pt, and 750 parts per million Etch. The sample was cured by heating at 200 °C to form 1.8 mm thick specimens. The specimens were aged at 200 °C for up to 14 days, and per cent transmission at 400 nm was measured at various times, The results are in Table 1.

### Example 1- Effect of Inhibitor.

A sample was prepared by mixing the following ingredients: 54 parts M^{Vi}_{0.25}T^{Ph}_{0.75}, 24 parts M^{Vi}₂D^{Ph,Me}x, 21 parts M^{Vi}_{0.6}T^{Ph}_{0.4}, 1 part Mold Release Agent, 2 parts Pt, and 250 parts per million Inhibitor. The sample was cured by heating at 200 °C to form 1.8 mm thick specimens. The specimens were aged at 200 °C for up to 14 days, and per cent transmission at 400 nm was measured at various times. The results are in Table 1.

**Table 1**

| % Transmission at 400 nm at 1.8 mm thickness | Un-aged | 1 day 200 °C | 7 day 200 °C | 14 day 200 °C |
|---|---|---|---|---|
| Comparative Example 1 | 97 | 96 | 92 | 92 |
| Example 1 | 98 | 98 | 98 | 98 |

Example 1 and comparative example 1 show that this invention may be used to prepare a cured silicone resin with an optical transparency > 95% at a thickness of 1.8 mm at 400 nm wavelength after heating at 200 °C for 14 days. Comparative example 1 shows that conventional organic acetylenic alcohol inhibitors for hydrosilylation curable silicone compositions, such as 1-ethynyl-1-cyclohexanol, may be unsuitable for preparing cured silicone resins with an optical transparency > 95% at a thickness of 1.8 mm at 400 nm wavelength after heating at 200 °C for 14 days.

## Claims

1. A composition comprising:
(A) a polydiorganosiloxane having an average, per molecule, of at least two aliphatically unsaturated organic groups and at least one aromatic group;
(B) a branched polyorganosiloxane having an average, per molecule, of at least one aliphatically unsaturated organic group and at least one aromatic group;
(C) a polyorganohydrogensiloxane having an average per molecule of at least two silicon-bonded hydrogen atoms and at least one aromatic group,
(D) a hydrosilylation catalyst, and
(E) a silylated acetylenic inhibitor.

2. The composition of claim 1, where ingredient (A) has formula R¹₃SiO-(R²₂SiO)ₐ-SiR¹₃, where each R¹ and each R² are independently selected from the group consisting of aliphatically unsaturated organic groups, aromatic groups and monovalent substituted and unsubstituted hydrocarbon groups free of aromatics and free aliphatic unsaturation, subscript a is an integer having a value sufficient to provide ingredient (A) with a viscosity ranging from 10 to 1,000,000 mPa·s at 25 °C, with the proviso that on average at least two of R¹ and/or R² are unsaturated organic groups and at least one of R¹ and/or R² is an aromatic group.

3. The composition of claim 1, where ingredient (B) has unit formula
(R³SiO_{3/2})_{b}(R³2SiO_{2/2})_{c}(R³₃SiO_{1/2})_{d}(SiO_{4/2})ₑ(XO_{1/2})_{f},
where each R³ is independently selected from the group consisting of aliphatically unsaturated organic groups, aromatic groups, and monovalent substituted and unsubstituted hydrocarbon groups free of aromatics and free aliphatic unsaturation, with the proviso that on average, per molecule, at least one of R³ is an aliphatically unsaturated organic group and at least one R³ is an aromatic group; X is a hydrogen atom or a monovalent hydrocarbon group; b is a positive number; c is 0 or a positive number; d is 0 or a positive number; e is 0 or a positive number; f is 0 or a positive number; c/b is a number ranging from 0 to 10; d/b is a number ranging from 0 to 0.5; e/(b+c+d+e) is a number ranging from 0 to 0.3; and f/(b+c+d+e) is a number ranging from 0 to 0.4.

4. The composition of claim 1, where ingredient (C) comprises a branched polyorganohydrogensiloxane of unit formula
(R⁵SiO_{3/2})ₕ(R⁵₂SiO_{2/2})ᵢ(R⁵₃SiO_{1/2})ⱼ(SiO_{4/2})ₖ(XO)ₘ
where X is a hydrogen atom or a monovalent hydrocarbon group; each R⁵ is independently a hydrogen atom, an aromatic group, or a monovalent substituted or unsubstituted hydrocarbon group free of aromatics and free aliphatic unsaturation, with the proviso that an average of at least two per molecule of R⁵ are hydrogen atoms, and an average of at least one per molecule of R⁵ is an aromatic group; h is a positive number; i is 0 or a positive number; j is 0 or a positive number; k is 0 or a positive number; m is 0 or a positive number; i/h has a value ranging from 0 to 10; j/h has a value ranging from 0 to 5; k/(h+i+j+k) has a value ranging from 0 to 0.3; and m/(h+i+j+k) has a value ranging from 0 to 0.4.

5. The composition of claim 1, where ingredient (D) comprises a complex of platinum with an organopolysiloxane.

6. The composition of claim 1, where ingredient (E) has a formula selected from the group consisting of: 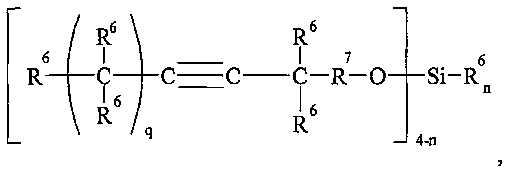 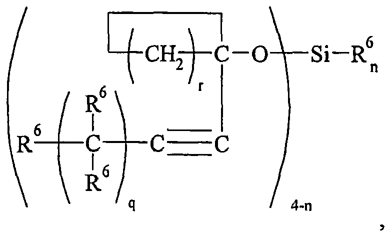 and a combination thereof; where each R⁶ is independently selected from the group consisting of a hydrogen atom and a monovalent organic group; n is 0, 1, 2, or 3, q is 0 to 10, and r is 4 to 12.

7. The composition of claim 1, further comprising an additional ingredient selected from the group consisting of (F) a mold release agent, (G) an optically active agent, (H) a filler, (I) an adhesion promoter, (J) a heat stabilizer, (K) a flame retardant, (L) a reactive diluent, or a combination thereof.

8. The composition of claim 7, where ingredient (F) is present and has formula HOR⁸₂SiO-(R⁸₂SiO)ₒ-SiR⁸₂OH, where each R⁸ is independently an aromatic group or a monovalent substituted or unsubstituted hydrocarbon group free of aromatics and free aliphatic unsaturation, with the proviso that on average at least one R⁸ per molecule is an aromatic group, and o is an integer with a value of 1 or more.

9. A method of preparing the composition of any one of claims 1-8 comprising mixing ingredients comprising ingredients (A), (B), (C), (D), and (E) at ambient or elevated temperature.

10. A method of preparing a multiple part composition according to any one of claims 1-8 comprising:
(I) preparing a base part by mixing ingredients comprising 30 to 60 parts ingredient (A), 30 to 65 parts ingredient (B), and 0.0005 to 0.002 parts ingredient (D);
(II) preparing a curing agent part by mixing ingredients comprising 0 to 10 parts ingredient (A), 42 to 67 parts by weight ingredient (B), 20 to 50 parts by weight ingredient (C); and 0.001 to 1 parts by weight ingredient (E); and
(III) storing the base part and the curing agent part in separate containers.

11. The method of claim 10 further comprising (IV) mixing the base part and the curing agent part together in a ratio of 1 to 10 parts base per 1 part curing agent.

12. Use of the composition of any one of claims 1-8 for packaging an optoelectronic device.

13. A cured silicone resin from the composition of any one of claims 1-8.

14. The cured silicone resin of claim 13, where the cured silicone resin has a refractive index > 1.40 and an optical transparency > 95% at a thickness of 2.0 mm or less at 400 nm wavelength after thermal aging by heating at 200 °C for 14 days

15. An LED device comprising: a lead frame 105, an LED chip 104 mounted to the lead frame 105, a soft silicone 103 encapsulating the LED chip 104, a dome 101 surrounding the LED chip 104, the soft silicone 103, and at least a portion of the lead frame 105, where the dome 101 is made of a cured silicone resin from a composition according to any one of claims 1-8.

16. A method for reducing yellowing of a cured silicone resin comprising adding a silylated acetylenic inhibitor to a curable silicone composition used to prepare the cured silicone resin, where the curable silicone composition comprises
(A) a polydiorganosiloxane having an average, per molecule, of at least two aliphatically unsaturated organic groups and at least one aromatic group;
(B) a branched polyorganosiloxane having an average, per molecule, of at least one aliphatically unsaturated organic group and at least one aromatic group;
(C) a polyorganohydrogensiloxane having an average per molecule of at least two silicon-bonded hydrogen atoms and at least one aromatic group, and
(D) a hydrosilylation catalyst.

## Patentansprüche

1. Zusammensetzung, die Folgendes umfasst:
(A) ein Polydiorganosiloxan mit durchschnittlich mindestens zwei aliphatisch ungesättigten organischen Gruppen und mindestens einer aromatischen Gruppe pro Molekül;
(B) ein verzweigtes Polyorganosiloxan mit durchschnittlich mindestens einer aliphatisch ungesättigten organischen Gruppe und mindestens einer aromatischen Gruppe pro Molekül;
(C) ein Polyorganohydrogensiloxan mit durchschnittlich mindestens zwei siliciumgebundenen Wasserstoffatomen und mindestens einer aromatischen Gruppe pro Molekül,
(D) einen Hydrosilylierungskatalysator und
(E) einen silylierten acetylenischen Inhibitor.

2. Zusammensetzung nach Anspruch 1, wobei Bestandteil (A) die Formel R¹₃SiO-(R²₂SiO)ₐ-SiR¹₃ aufweist, wobei jedes R¹ und jedes R² unabhängig aus der Gruppe bestehend aus aliphatisch ungesättigten organischen Gruppen, aromatischen Gruppen und einwertigen substituierten und unsubstituierten Kohlenwasserstoffgruppen, die frei von Aromaten und frei von aliphatischer Ungesättigtheit sind, ausgewählt sind, und das tiefgestellte a eine ganze Zahl mit einem Wert ist, der ausreicht, um Bestandteil (A) mit einer Viskosität auszustatten, die von 10 bis 1.000.000 mPa·s bei 25 °C reicht, mit der Maßgabe, dass durchschnittlich mindestens zwei der R¹ und/oder R² ungesättigte organische Gruppen sind und mindestens eines der R¹ und/oder R² eine aromatische Gruppe ist.

3. Zusammensetzung nach Anspruch 1, wobei Bestandteil (B) die Einheitsformel
(R₃SiO_{3/2})_{b}(R³₂SiO_{2/2})_{c}(R³₃SiO_{1/2})_{d}(SiO_{4/2})ₑ(XO_{1/2})_{f}
aufweist, wobei jedes R³ unabhängig aus der Gruppe bestehend aus aliphatisch ungesättigten organischen Gruppen, aromatischen Gruppen und einwertigen substituierten und unsubstituierten Kohlenwasserstoffgruppen, die frei von Aromaten und frei von aliphatischer Ungesättigtheit sind, ausgewählt ist, mit der Maßgabe, dass durchschnittlich mindestens eines der R³ pro Molekül eine aliphatische ungesättigte organische Gruppe ist und mindestens ein R³ eine aromatische Gruppe ist; X ein Wasserstoffatom oder eine einwertige Kohlenwasserstoffgruppe ist; b eine positive Zahl ist; c 0 oder eine positive Zahl ist; d 0 oder eine positive Zahl ist; e 0 oder eine positive Zahl ist; f 0 oder eine positive Zahl ist; c/b eine Zahl ist, die von 0 bis 10 reicht; d/b eine Zahl ist, die von 0 bis 0,5 reicht; e/(b+c+d+e) eine Zahl ist, die von 0 bis 0,3 reicht; und f/(b+c+d+e) eine Zahl ist, die von 0 bis 0,4 reicht.

4. Zusammensetzung nach Anspruch 1, wobei Bestandteil (C) ein verzweigtes Polyorganohydrogensiloxan der Einheitsformel (R⁵SiO_{3/2})ₕ(R⁵₂SiO_{2/2})ᵢ(R⁵₃SiO_{1/2})ⱼ(SiO_{4/2})ₖ(XO)ₘ umfasst, wobei X ein Wasserstoffatom oder eine einwertige Kohlenwasserstoffgruppe ist; jedes R⁵ unabhängig ein Wasserstoffatom, eine aromatische Gruppe oder eine einwertige substituierte oder unsubstituierte Kohlenwasserstoffgruppe, die frei von Aromaten und frei von aliphatischer Ungesättigtheit ist, ist, mit der Maßgabe, dass durchschnittlich mindestens zwei der R⁵ pro Molekül Wasserstoffatome sind und durchschnittlich mindestens eines der R⁵ pro Molekül eine aromatische Gruppe ist; h eine positive Zahl ist; i 0 oder eine positive Zahl ist; j 0 oder eine positive Zahl ist; k 0 oder eine positive Zahl ist; m 0 oder eine positive Zahl ist; i/h einen Wert hat, der von 0 bis 10 reicht; j/h einen Wert hat, der von 0 bis 5 reicht; k/(h+i+j+k) einen Wert hat, der von 0 bis 0,3 reicht; und m/(h+i+j+k) einen Wert hat, der von 0 bis 0,4 reicht.

5. Zusammensetzung nach Anspruch 1, wobei Bestandteil (D) einen Platinkomplex mit einem Organopolysiloxan umfasst.

6. Zusammensetzung nach Anspruch 1, wobei Bestandteil (E) eine Formel aufweist, die aus der Gruppe bestehend aus: 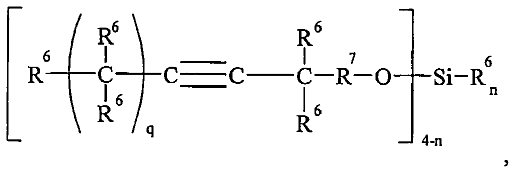 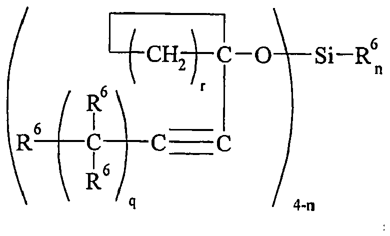 und einer Kombination davon ausgewählt ist; wobei jedes R⁶ unabhängig aus der Gruppe bestehend aus einem Wasserstoffatom und einer einwertigen organischen Gruppe ausgewählt ist; n 0, 1, 2 oder 3 ist, q 0 bis 10 ist und r 4 bis 12 ist.

7. Zusammensetzung nach Anspruch 1, die weiterhin einen zusätzlichen Bestandteil umfasst, der aus der Gruppe bestehend aus (F) einem Formtrennmittel, (G) einer optisch aktiven Substanz, (H) einem Füllstoff, (I) einem Haftvermittler, (J) einem Wärmestabilisator, (K) einem Flammschutzmittel, (L) einem reaktiven Verdünnungsmittel oder einer Kombination davon ausgewählt ist.

8. Zusammensetzung nach Anspruch 7, wobei Bestandteil (F) vorhanden ist und die Formel HOR⁸₂SiO-(R⁸₂SiO)ₒ-SiR⁸₂OH aufweist, wobei jedes R⁸ unabhängig eine aromatische Gruppe oder eine einwertige substituierte oder unsubstituierte Kohlenwasserstoffgruppe, die frei von Aromaten und frei von aliphatischer Ungesättigtheit ist, ist, mit der Maßgabe, dass durchschnittlich mindestens eines der R⁸ pro Molekül eine aromatische Gruppe ist und o eine ganze Zahl mit einem Wert von 1 oder mehr ist.

9. Verfahren zur Herstellung der Zusammensetzung nach einem der Ansprüche 1 - 8, wobei das Verfahren das Mischen von Bestandteilen, die die Bestandteile (A), (B), (C), (D) und (E) umfassen, bei Umgebungstemperatur oder erhöhter Temperatur umfasst.

10. Verfahren zur Herstellung einer Mehrkomponentenzusammensetzung nach einem der Ansprüche 1 - 8, wobei das Verfahren Folgendes umfasst:
(I) Herstellen einer Basiskomponente durch Mischen von Bestandteilen, die 30 bis 60 Teile Bestandteil (A), 30 bis 65 Teile Bestandteil (B) und 0,0005 bis 0,002 Teile Bestandteil (D) umfassen;
(II) Herstellen einer Härterkomponente durch Mischen von Bestandteilen, die 0 bis 10 Teile Bestandteil (A), 42 bis 67 Gewichtsteile Bestandteil (B), 20 bis 50 Gewichtsteile Bestandteil (C) und 0,001 bis 1 Gewichtsteil Bestandteil (E) umfassen; und
(III) Lagern der Basiskomponente und der Härterkomponente in separaten Behältern.

11. Verfahren nach Anspruch 10, das weiterhin (IV) das Vermischen der Basiskomponente und der Härterkomponente in einem Verhältnis von 1 bis 10 Teilen Basis pro 1 Teil Härter umfasst.

12. Verwendung der Zusammensetzung nach einem der Ansprüche 1 - 8 zum Verpacken eines optoelektronischen Bauelements.

13. Gehärtetes Silikonharz aus der Zusammensetzung nach einem der Ansprüche 1 - 8.

14. Gehärtetes Silikonharz nach Anspruch 13, wobei das gehärtete Silikonharz einen Brechungsindex > 1,40 und eine optische Transparenz > 95 % bei einer Dicke von 2,0 mm oder weniger bei einer Wellenlänge von 400 nm nach thermischer Alterung durch Erhitzen bei 200 °C für 14 Tage aufweist.

15. LED-Bauelement, das Folgendes umfasst: einen Leiterrahmen 105, einen LED-Chip 104, der auf dem Leiterrahmen 105 montiert ist, ein Weichsilikon 103, das den LED-Chip 104 einkapselt, und einen Dom 101, der den LED-Chip 104, das Weichsilikon 103 und mindestens einen Teil des Leiterrahmens 105 umschließt, wobei der Dom 101 aus einem gehärteten Silikonharz aus einer Zusammensetzung nach einem der Ansprüche 1 - 8 hergestellt ist.

16. Verfahren zur Verringerung des Vergilbens eines gehärteten Silikonharzes, wobei das Verfahren das Zugeben eines silylierten acetylenischen Inhibitors zu einer härtbaren Silikonzusammensetzung umfasst, die dazu verwendet wird, das gehärtete Silikonharz herzustellen, wobei die härtbare Silikonzusammensetzung Folgendes umfasst:
(A) ein Polydiorganosiloxan mit durchschnittlich mindestens zwei aliphatisch ungesättigten organischen Gruppen und mindestens einer aromatischen Gruppe pro Molekül;
(B) ein verzweigtes Polyorganosiloxan mit durchschnittlich mindestens einer aliphatisch ungesättigten organischen Gruppe und mindestens einer aromatischen Gruppe pro Molekül;
(C) ein Polyorganohydrogensiloxan mit durchschnittlich mindestens zwei siliciumgebundenen Wasserstoffatomen und mindestens einer aromatischen Gruppe pro Molekül und
(D) einen Hydrosilylierungskatalysator.

## Revendications

1. Composition comprenant :
(A) un polydiorganosiloxane ayant une moyenne, par molécule, d'au moins deux groupements organiques insaturés aliphatiquement et au moins un groupement aromatique ;
(B) un polyorganosiloxane ramifié ayant une moyenne, par molécule, d'au moins un groupement organique insaturé aliphatiquement et au moins un groupement aromatique ;
(C) un polyorganohydrogénosiloxane ayant une moyenne par molécule d'au moins deux atomes d'hydrogène liés par silicium et au moins un groupement aromatique ;
(D) un catalyseur d'hydrosilylation ; et
(E) un inhibiteur acétylénique silylé.

2. Composition selon la revendication 1, dans laquelle l'ingrédient (A) a la formule R¹₃SiO-(R²₂SiO)ₐ-SiR¹₃, où chaque R¹ et chaque R² est indépendamment sélectionné parmi le groupe constitué de groupements organiques insaturés aliphatiquement, de groupements aromatiques et de groupements hydrocarbures substitués et non substitués monovalents libres d'hydrocarbures aromatiques et une insaturation aliphatique libre, l'indice a est un entier ayant une valeur suffisante pour fournir à l'ingrédient (A) une viscosité allant de 10 à 1 000 000 mPa·s à 25° C, à la condition qu'en moyenne au moins deux parmi R¹ et/ou R² soient des groupements organiques insaturés et au moins un parmi R¹ et/ou R² soit un groupement aromatique.

3. Composition selon la revendication 1, dans laquelle l'ingrédient (B) a une formule unitaire (R³SiO_{3/2})_{b}(R³₂SiO_{2/2})_{c}(R³₃SiO_{1/2})_{d}(SiO_{4/2})ₑ(XO_{1/2})_{f}, où chaque R³ est indépendamment sélectionné parmi le groupe constitué de groupements organiques insaturés aliphatiquement, de groupements aromatiques, et de groupements hydrocarbures substitués et non substitués monovalents libres d'hydrocarbures aromatiques et une insaturation aliphatique libre, à la condition qu'en moyenne, par molécule, au moins un parmi R³ soit un groupement organique insaturé aliphatiquement et au moins un R³ soit un groupement aromatique ; X est un atome d'hydrogène ou un groupement hydrocarbure monovalent ; b est un nombre positif ; c est 0 ou un nombre positif ; d est 0 ou un nombre positif ; e est 0 ou un nombre positif ; f est 0 ou un nombre positif ; c / b est un nombre allant de 0 à 10 ; d / b est un nombre allant de 0 à 0,5 ; e / (b + c + d + e) est un nombre allant de 0 à 0,3 ; et f / (b + c + d + e) est un nombre allant de 0 à 0,4.

4. Composition selon la revendication 1, dans laquelle l'ingrédient (C) comprend un polyorganohydrogénosiloxane ramifié de formule unitaire (R⁵SiO_{3/2})ₕ(R⁵₂SiO_{2/2})ᵢ(R⁵₃SiO_{1/2})ⱼ(SiO_{4/2})ₖ(XO)ₘ, où X est un atome d'hydrogène ou un groupement hydrocarbure monovalent ; chaque R⁵ est indépendamment un atome d'hydrogène, un groupement aromatique, ou un groupement hydrocarbure substitué ou non substitué monovalent libre d'hydrocarbures aromatiques et une insaturation aliphatique libre, à la condition qu'une moyenne par molécule d'au moins deux parmi R⁵ soient des atomes d'hydrogène, et une moyenne par molécule d'au moins un parmi R⁵ soit un groupement aromatique ; h est un nombre positif ; i est 0 ou un nombre positif ; j est 0 ou un nombre positif ; k est 0 ou un nombre positif ; m est 0 ou un nombre positif ; i /h a une valeur allant de 0 à 10 ; j / h a une valeur allant de 0 à 5 ; k / (h + i + j + k) a une valeur allant de 0 à 0,3 ; et m / (h + i + j + k) a une valeur allant de 0 à 0,4.

5. Composition selon la revendication 1, dans laquelle l'ingrédient (D) comprend un complexe de platine avec un organopolysiloxane.

6. Composition selon la revendication 1, dans laquelle l'ingrédient (E) a une formule sélectionnée parmi le groupe constitué de : 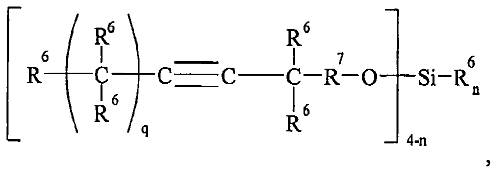 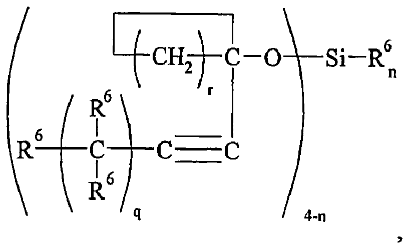 et une combinaison de celles-ci ; où chaque R⁶ est indépendamment sélectionné parmi le groupe constitué d'un atome d'hydrogène et d'un groupement organique monovalent ; n est 0, 1, 2, ou 3, q est 0 à 10, et r est 4 à 12.

7. Composition selon la revendication 1, comprenant en outre un ingrédient supplémentaire sélectionné parmi le groupe constitué de (F) un agent démoulant, (G) un agent optiquement actif, (H) une charge, (I) un promoteur d'adhésion, (J) un stabilisant thermique, (K) un produit ignifugeant, (L) un diluant réactif, ou une combinaison de ceux-ci.

8. Composition selon la revendication 7, dans laquelle l'ingrédient (F) est présent et a la formule HOR⁸₂SiO-(R⁸₂SiO)₀-SiR⁸₂OH, où chaque R⁸ est indépendamment un groupement aromatique ou un groupement hydrocarbure substitué ou non substitué monovalent libre d'hydrocarbures aromatiques et une insaturation aliphatique libre, à la condition qu'en moyenne au moins un R⁸ par molécule soit un groupement aromatique, et o soit un entier avec une valeur de 1 ou plus.

9. Procédé de préparation de la composition selon l'une quelconque des revendications 1 à 8, comprenant l'étape consistant à mélanger des ingrédients comprenant les ingrédients (A), (B), (C), (D), et (E) à la température ambiante ou à une température élevée.

10. Procédé de préparation d'une composition à parties multiples selon l'une quelconque des revendications 1 à 8 comprenant les étapes consistant à :
(I) préparer une partie de base en mélangeant des ingrédients comprenant 30 à 60 parties d'ingrédient (A), 30 à 65 parties d'ingrédient (B), et 0,0005 à 0,002 partie d'ingrédient (D) ;
(II) préparer une partie d'agent de durcissement en mélangeant des ingrédients comprenant 0 à 10 parties d'ingrédient (A), 42 à 67 parties en poids d'ingrédient (B), 20 à 50 parties en poids d'ingrédient (C) ; et 0,001 à 1 partie en poids d'ingrédient (E) ; et
(III)stocker la partie de base et la partie d'agent de durcissement dans des récipients séparés.

11. Procédé selon la revendication 10, comprenant en outre l'étape (IV) consistant à mélanger ensemble la partie de base et la partie d'agent de durcissement selon un rapport d'1 à 10 parties de base pour 1 partie d'agent de durcissement.

12. Utilisation de la composition selon l'une quelconque des revendications 1 à 8, pour emballer un dispositif optoélectronique.

13. Résine de silicone durcie de la composition selon l'une quelconque des revendications 1 à 8.

14. Résine de silicone durcie selon la revendication 13, dans laquelle la résine de silicone durcie a un indice de réfraction > 1,40 et une transparence optique > 95 % à une épaisseur de 2,0 mm maximum à une longueur d'ondes de 400 nm après un vieillissement thermique par chauffage à 200° C pendant 14 jours.

15. Dispositif à DEL comprenant : une grille de connexion 105, une puce à DEL 104 montée sur la grille de connexion 105, une silicone souple 103 encapsulant la puce à DEL 104, un dôme 101 entourant la puce à DEL 104, la silicone souple 103, et au moins une portion de la grille de connexion 105, dans lequel le dôme 101 est fabriqué dans une résine de silicone durcie d'une composition selon l'une quelconque des revendications 1 à 8.

16. Procédé de réduction du jaunissement d'une résine de silicone durcie comprenant l'étape consistant à ajouter un inhibiteur acétylénique silylé à une composition de silicone durcissable utilisée pour préparer la résine de silicone durcie, dans lequel la composition de silicone durcie comprend
(A) un polydiorganosiloxane ayant une moyenne, par molécule, d'au moins deux groupements organiques insaturés aliphatiquement et au moins un groupement aromatique ;
(B) un polyorganosiloxane ramifié ayant une moyenne, par molécule, d'au moins un groupement organique insaturé aliphatiquement et au moins un groupement aromatique ;
(C) un polyorganohydrogénosiloxane ayant une moyenne par molécule d'au moins deux atomes d'hydrogène liés par silicium et au moins un groupement aromatique ; et
(D) un catalyseur d'hydrosilylation.
